(19) Europäisches Patentamt
European Patent Office
Office européen des brevets

(11) Publication number: 0 052 227 A1

# (12) EUROPEAN PATENT APPLICATION

(21) Application number: 81108135.5

(22) Date of filing: 09.10.81

(51) Int. Cl.$^3$: H 01 L 21/306

(30) Priority: 19.11.80 US 208216

(43) Date of publication of application: 26.05.82 Bulletin 82/21

(84) Designated Contracting States: DE FR GB IT

(71) Applicant: International Business Machines Corporation
Armonk, N.Y. 10504(US)

(72) Inventor: Purcell, Edward Donald
167 Curtis Ave.
Burlington Vermont 05401(US)

(72) Inventor: White, Francis Roger
66 Greenfield Road
Essex Junction Vermont 05452(US)

(72) Inventor: Wursthorn, John Michael
Plesant Valley Road
Underhill Ctr. Vermont 05490(US)

(74) Representative: Oechssler, Dietrich Dr. rer. nat.
Schönaicher Strasse 220
D-7030 Böblingen(DE)

## (54) Method for forming a self-aligned contact and a plasma especially applicable in performing said method.

(57) The method is applied after the contact region (27a) has been covered by a silicon nitride oxidation blocking mask (28a) which subsequently was subjected to oxidation and/or doping processes causing the formation of various compounds in the silicon nitride (28a) and at the interface between the silicon nitride (28a) and the contact region (27a). A non-selective etching process is used to remove silicon nitride (28a) and the formed compounds. In particular it has been found that a plasma comprising a organo-halide and an excess of oxygen can be used to non-selectively etch the silicon dioxide, the silicon nitride, its associated compounds and the material of the contact region, like polysilicon. The method is useful e.g. for the formation of the polysilicon gate of a silicon field effect transistor.

30
31
29a
23
27a
28a
23
22
26

FIG. 4

28a
23
34
35
23
36
38
37
22
32
27a
26a
33

FIG. 5

23
40
27a
23
22
32
26a
33

FIG. 6

EP 0 052 227 A1

Croydon Printing Company Ltd.

METHOD FOR FORMING A SELF-ALIGNED CONTACT AND A PLASMA ESPECIALLY APPLICABLE IN PERFORMING SAID METHOD

The invention relates to a method for forming a self-aligned contact to an region of an integrated circuit to be produced said region previously having been protected by a silicon nitride oxidation blocking mask which subsequently has undergone an oxidation and/or doping process, and a plasma for etching silicon nitride and especially applicable in said method.

In the formation of complex integrated circuit structures a number of layers of different compounds are utilized. Some of these layers are used but for a single step and then removed while others are never removed but only modified by thinning, thickening or the like. Still others are exposed to many steps in the process. Some of these steps can so modify the structure of the layers, e.g. by rendering them chemically complex, that they become virtually impossible to remove in a single step without materially attacking other layers which are not to be removed.

It is the object of the invention to provide a method to remove silicon nitride, compounds obtained from the silicon nitride e.g. in oxidation and doping steps and also material formed at the interface between the silicon nitride and the underlying region said method deleteriously affecting neither the structure nor form of other layers associated with the layers being removed and a plasma that is applicable in this removal step.

This object is achieved by a method as defined at the beginning of this specification, using the characterizing part of claim 1 and by a plasma as defined at the beginning of this specification using the features of the characterizing part of claim 7.

With the inventive method selected layers from the surface of a body are removed regardless of the chemical or structural complexity of the layer being removed.

Other advantageous embodiments of the method and of the plasma in accordance with the invention are disclosed in the subclaims.

The invention will become more apparent from the following detailed description taken in conjunction with the accompanying drawings.

| | |
|---|---|
| Fig. 1 | is a schematic view of a plasma etching chamber in which the present invention can be practiced. |
| Figs. 2 to 6 | illustrate, in cross section, a typical semiconductor slice at various steps in the process of making a semiconductor transistor. |

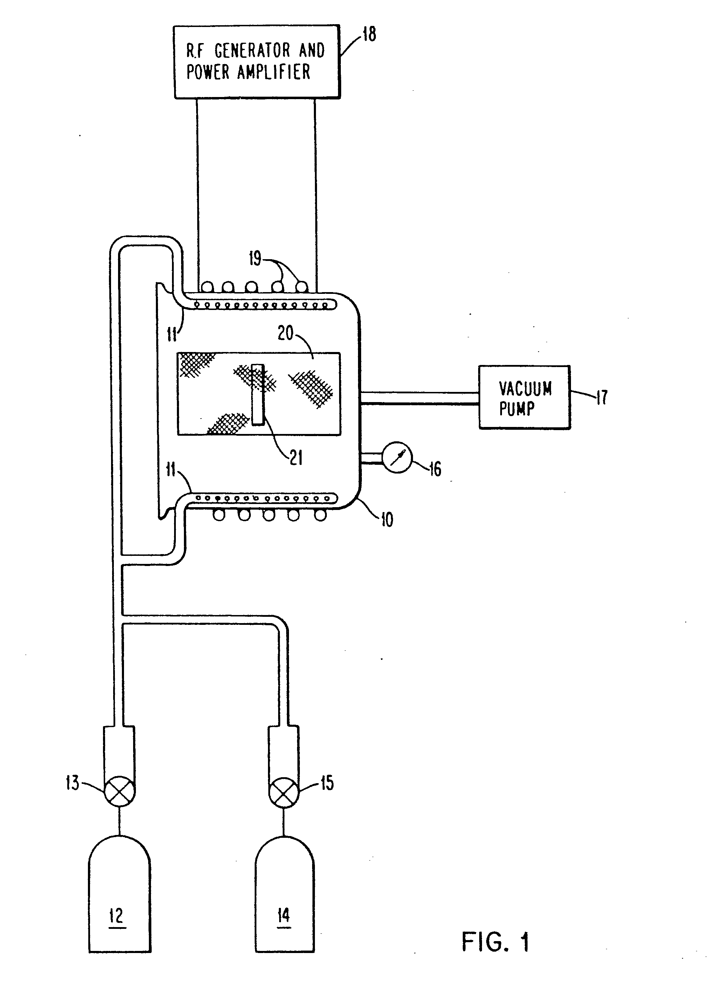

Fig. 1 depicts schematically an apparatus for use in practicing the invention. The apparatus includes a glass reaction chamber 10, typically made of quartz, provided with a gas inlet manifold 11. An oxygen supply 12 is connected through a flowmeter 13 to manifold 11. A supply 14 of an organo-halide gas, i. e. a carbon-halide gas, is also connected to the manifold 11 through a second flowmeter 15. A pressure guage 16 is connected to the chamber 10 and is used to indicate the pressure within chamber 10.

A vacuum pump 17 is also connected to the chamber 10 to assure that the desired pressure is maintained in the chamber 10. A source of radio frequency power 18 is coupled to a coil or capacitor plates 19 surrounding the chamber 10. Centrally located in chamber 10 there is an electrically floating metallic mesh or screen 20 whose axis is parallel to the axis of the chamber 10 and to the RF coil 19. The semiconductor body 21 to be treated in this apparatus is located within the screen 20. Such an apparatus is sold by the International Plasma Corporation under the description of Model 2005T-1818.

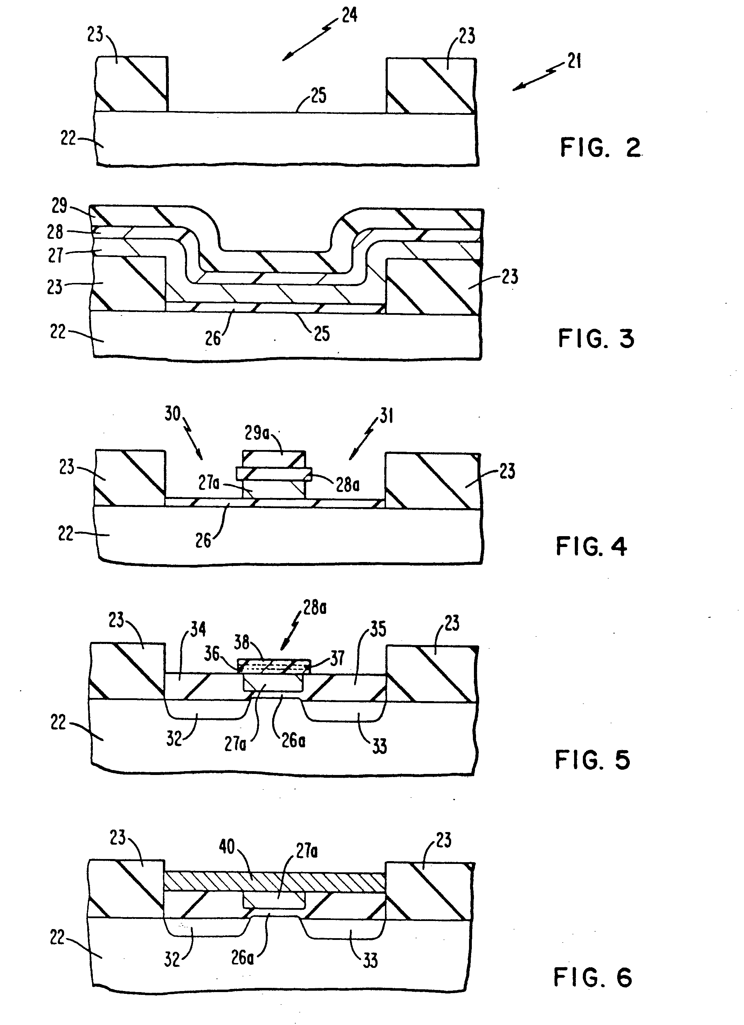

The detailed use of this apparatus will best be understood from the following description of a specific embodiment of the invention taken in conjunction with Figs. 2 to 6.

In Fig. 2 there is shown a semiconductor body generally designated 21 which comprises a substrate 22 of a single crystal semiconductor material, doped for example with p-type dopants, having a field oxide 23, with a thickness of between 400 and 500 nm, grown thereon. This field oxide maybe grown by exposing the substrate 22 to a wet oxygen atmosphere at a temperature of 1000°C for 70 to 100 minutes. After the oxide layer 23 is grown, the unit is washed and etched using known techniques to remove a portion of the field oxide 23 and provide an opening 24 therein. This opening exposes an area of the substrate surface 25. Recessed oxide techniques also known to the industry may be used to provide the field oxide and opening.

After cleaning, the unit is again exposed to an oxidizing atmosphere for a time sufficient to form a gate oxide layer 26 on the surface 25. This gate oxide layer 26 may range from 25 to 100 nm and typically is 45 nm thick. Once this gate oxide 26 has been formed to the desired thickness a polysilicon layer 27 is formed. This layer may be formed by using well known techniques such as chemical vapor deposition processes. Typically this layer is about 400 nm in thickness.

Over this polysilicon layer 27 a silicon nitride layer 28, approximately 30 nm in thickness, is formed by known chemical vapor deposition techniques. The unit is now coated with a 1200 nm thick layer 29 of photoresist. The unit at this time appears as shown in Fig. 3.

Layer 29 is treated so that only layer 29a, as shown in Fig. 4, is left so as to define what will become the transistor gate region. A source opening 30 and a drain opening 31 are provided on either side of layer 29a using well known techniques. In these openings 30 and 31, the exposed portion, i. e. the portions unprotected by photoresist layer 29a of the silicon nitride forming layer 28 can be removed by using buffered HF. For thick layers a hot phosporic acid technique using an oxide mask might be preferred.

After the silicon nitride has been etched so that only the layer 28a is left, as shown in Fig. 4, the unit is etched with a nitric-hydroflouric acid solution and the polysilicon layer 27 is reduced to area 27a. This region 27a underlies the protected silicon nitride layer 28a and the photoresist layer 29a. Alternately a dry plasma etch using an organohalide such as CF4 having 4% to 16% oxygen could be used to selectively remove the polysilicon in the source and drain region. The gate oxide layer 26 is left untouched. The unit now appears as is shown in Fig. 4.

The photoresist layer 29a is removed and the unit is placed in an ion implantation apparatus (not shown) and exposed to, for example, a dose of $8.0x10^{15}/cm^{2}$ of 80Kev arsenic ions. These ions pass through the thin gate oxide layer 26 where it is exposed in the source and drain openings 30 and 31 to form a source region 32 and a drain region 33.

Because of the thickness of the field oxide layer 23 and the layers 27a and 28a these ions do not reach the substrate under these areas and only the source and drain regions 32 and 33 are implanted.

Subsequent to this ion implantation step, the entire unit is heated at a temperature of 1000°C in an oxidizing atmosphere to thicken the oxide over the source and drain regions to between 250 and 300 nm as indicated by oxide layers 34 and 35 and to cause the implanted arsenic ions to diffuse deeper into the substrate. This drive step also anneals the source and drain regions 32 and 33.

Because the polysilicon island 27a is to be used as a gate electrode to control current flow between the source 32 and drain 33 it becomes necessary to remove the remaining silicon nitride layer 28a so that an electrical contact can be made to layer 27a.

In previous prior art attempts to remove this layer 28a very selective wet etches that would attack only the silicon nitride layer were used with generally unsatisfactory results.

The problem was this. When forming the source and drain regions energetic arsenic ions would be introduced into the silicon nitride layer 28a altering the structure of the layer 28a. Possibly some form of a silicon-nitride-arsenic compound could be formed in the layer 28a.

Then during the subsequent formation of the source and drain oxide layers 34 and 35 a thin oxy-nitride film 38 is usually formed over the layer 28a. Also the arsenic could out-diffuse from the lower layers of 28a and 27a. Thus this top layer could be a complex silicon nitride-oxide-arsenic compound or mixture.

This lower portion 36 of layer 28a appears to be altered, by the oxidation and out-diffusion step, so that it is different from the upper portion of the silicon nitride layer. To illustrate this the layer 28a is shown divided into two layers 36 and 37.

This oxy-nitride film 38 will not etch in phosporic acid ($H_3PO_4$) but will etch in hydroflouric acid (HF). However, this HF etch also attacks the field oxide 23 and the source and drain oxides 34 and 35 and attacks them at a much higher rate. Thus before the oxy-nitride layer 38 is removed the other oxide layers are considerably thinned by the HF etch.

To remove the remaining layers 37 and 36 a hot phosporic acid ($H_3PO_4$) etch was required. However, it was found that because of variations in the layers caused by the ions and other previous treatments that the etch rates of these layers were slow, variable and unpredictable. Also it was found that often times a boundary of material unetchable in either HF or $H_3PO_4$ was formed between the polysilicon layer 27a and the overlying silicon nitride layer 28a.

No satisfactory solution to these problems was found until the present inventors conceived the solution described herein and developed an etchant, and a method that would etch all these layers 36, 37, and 38 in a known controlled manner and at approximately the same rate.

The process of the invention for the etching of the described layers is as follows:

After the growing of the oxide layers 34 and 35 as shown in Fig. 5, the semiconductor unit 21 is placed within the etch tunnel sleeve 20, as shown in Fig. 1. The entire chamber is evacuated by the vacuum pump 17 to less than 0.133 mbar. The RF power generator 18 is turned on and 200 watts of power is applied to the RF coils while a flow rate of 100 cubic centimeters per minute (SCCM) of oxygen was permitted to flow into the chamber 10 together with 18.8 SCCM of an organo-halide in this case, $CF_4$. With this flow into the chamber the pump is adjusted to hold the pressure in the chamber to 1.333 mbar.

With these conditions present the unit 21 is heated to the equilibrium temperature of about 150°C and a plasma is created within chamber 10 between the chamber walls and the screen 20. The plasma does not exist inside the electrically floating screen 20. Because of screen 20, only highly energetic non-charged particles comprised of highly reactive fluorine and oxygen atoms, compounds and radicals penetrate the screen. All charged particles are prevented from passing through the screen 20 into the region around the semiconductor unit 21.

Because the particles that do penetrate the region within the screen are highly reactive all the exposed surfaces of the unit 21 are etched. However, the etching of each layer is at a different controllable rate under the described condition. Thus the average etch rate of the complex silicon nitride-oxide-arsenic compound or mixture, i.e. layers 36, 37 and 38 is 3 nm/minute.

Simultaneously the oxide layers 34 and 35 and the field oxide 23 are etched at a rate of 10 nm/minute. The polysilicon layer 27a once it is exposed by the removal of the nitride layer 28a is etched at 9 nm/minute.

The above specified conditions supplying the above specified etch conditions was chosen to minimize the etch of the surrounding oxide layers 23, 34 and 35 and the underlying polysilicon layer 27a while still assuring that the silicon nitride layer 28a and compounds formed therewith, i. e. layers 36, 37 and 38, would be etched.

These conditions were maintained in the chamber for 4 minutes to assure that the entire thickness of the silicon nitride layer 28a was removed and that the surface of polysilicon layer 27a was completely cleaned.

In the first 2.3 minutes the entire layer of silicon nitride 28a was removed and during the next 1.7 minutes the top 15 nm of the now exposed polysilicon layer 27a was removed leaving a clean surface for metallization. During this same four minutes period 40 nm of the oxide layers 23, 34 and 35 were also removed.

Thus, the layer 28b was 100% removed while only 4% of the 400 nm thick polysilicon layer 27a was removed. Also the source/drain oxide layers 34 and 35 having a thickness of between 250 and 300 nm, had 16% or less removed. Since the field oxide layer 23, is at least 400 nm thick, less than 10% of it is removed. Thus these layers, i. e. the polysilicon layer 27a, the field oxide 23 and the source and drain oxides 34 and 35 are not adversely affected by the described etching sequence.

Thus there has been described a well controlled highly material non-selective etch process that etches all materials, deposited or grown on a semiconductor body at approximately the same rate. By adjusting the thickness of the various materials one or more may be selectively removed with this non-selective etch without materially impacting on or adversely affecting the other layer of material on the body.

It should be understood that the relative etch rates of these materials may be changed by changing selected ones of the parameters such as power, pressure, temperature and the $CF_4/O_2$ ratio. The pressure of course must always be sufficient to maintain a plasma at the selected power level. Similarly the temperature must be at least the equilibrium temperature required to sustain the plasma at the given pressure and power level. Generally speaking for the described apparatus the power level must be greater than 50 watts. It has also been found, in the described apparatus, that if the organo-halide-oxygen ratio is kept constant, say for example 85% $O_2$ and 15% $CF_4$, that with increasing power and/or pressure that the etching rate in nm per minute increases. In any event it must be understood that regardless of the change in the pressure, power, temperature parameters the organo-halide-oxygen ratio must be at least 1 that is the oxygen content of the gas must be at least equal to or greater than the organo-halide content. Preferrably the oxygen content of the gas should be approximately 4 times that of the organo-halide content of the gas.

It has been found that any organo-halide can be used in the described process provided that the oxygen content does not fall below the organo-halide content of the plasma formed in the chamber, that is the amount of oxygen must, at least, be equal to the amount of organo-halide used.

It should be understood that the gas forming the plasma can also contain, in addition to the above described organo-halides and oxygen, substantially non-reactive gases such as argon nitrogen, and xenon. These gases can be added to the organo-halide and oxygen mixture without adversely affecting the above described etching.

Once the silicon nitride layer 28a has been completely removed the metal layer 40 is deposited over the polysilicon layer 27a so that a good electrical contact can be made to layer 27a. Other metal contacts, not shown, are made to the source and drain diffusions 32 and 33.

CLAIMS

1. Method for forming a self-aligned contact to a region of an integrated circuit to be produced said region previously having been protected by a silicon nitride oxidation blocking mask (28a), which subsequently has undergone an oxidation and/or doping process, characterized in that the silicon nitride blocking mask (28a) is removed with an etchant which is substantially none-selective with respect to silicon dioxide, silicon nitride and the oxidation products thereof.

2. Method according to claim 1, wherein said etchant comprises uncharged reactive compounds, atoms and radicals extracted from a plasma.

3. Method according to claim 1 or 2, wherein the selective removal of defined materials is ensured by adjusting the thicknesses of the materials exposed to the etchant.

4. Method according to any one of claims 1 to 3, wherein the part to be produced is placed in a plasma generating tool, an electrically floating screen (20) is placed around said part, a gas capable of forming reactive compounds, atoms and radicals in a glow discharge is introduced into said tool, outside of said screen in said tool a plasma is greated from said gas and said plasma is maintained for a period of time sufficient for particles from said plasma to remove said blocking mask (28a).

5. Method according to any one of claims 1 to 4, wherein the region to be contacted is the gate (27a) of a field effect transistor.

6. Method according to any one of claims 1 to 5, wherein the region to be contacted is made of polysilicon.

7. A plasma for etching silicon nitride and especially applicable in the method according to any one of claims 2 to 6, characterized in that the plasma is created from a gas mixture containing an organo-halide gas and oxygen with the oxygen content being at least equal to the organo-halide gas content.

8. Plasma according to claim 7, wherein the oxygen content in the gas mixture comprises at least 50 and less than 100% by volume.

9. Plasma according to claims 7 or 8, wherein in addition a substantially inert gas is contained.

10. Plasma according to claim 9, wherein the inert gas is selected from the group consisting of argon, nitrogen and xenon.

R.F GENERATOR AND POWER AMPLIFIER
18
19
11
20
VACUUM PUMP
17
21
11
16
10
13
15
12
14

FIG. 1

24
23
23
21
25
22
29
28
27
23
23
22
26
25
30
31
29a
23
27a
28a
23
22
26
28a
23
34
38
23
36
37
35
22
32
27a
26a
33
23
40
27a
23
22
32
26a
33

FIG. 2

FIG. 3

FIG. 4

FIG. 5

FIG. 6

European Patent
Office

# EUROPEAN SEARCH REPORT

Application number

EP 81 10 8135.5

| Category | Citation of document with indication, where appropriate, of relevant passages | Relevant to claim | CLASSIFICATION OF THE APPLICATION (Int. Cl.³) |
|---|---|---|---|
| A | US - A - 4 180 432 (CLARK) * column 1, lines 46 to 59; column 2, table I * | 1,2, 7,8 | H 01 L 21/306 |
| A | US - A - 4 174 251 (PASCHKE) * claims 1 to 4 * | 2,7, 8 | |
| A | SOLID STATE TECHNOLOGY, Vol. 19, No. 6, June 1976 New York H.A. CLARK "Plasma Processing at Moderate Vacuum", pages 51 to 54 * page 51, first column, last paragraph; pages 51 to 53, sections "Silicon Dioxide" and "Silicon Nitride" * | 2, 7-9 | TECHNICAL FIELDS SEARCHED (Int. Cl.³) C 23 C 15/00 C 23 F 1/00 H 01 L 21/306 H 01 L 21/31 |
| A | US - A - 4 192 706 (HORIIKE) * claim; fig. 1 * | 4 | |
| A | US - A - 4 183 040 (RIDEOUT) * column 11, line 60 to column 13, line 32 * | | |

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

X The present search report has been drawn up for all claims

| Place of search | Date of completion of the search | Examiner |
|---|---|---|
| Berlin | 11-02-1982 | GIBBS |